# EUROPEAN PATENT APPLICATION

(11) **EP 2 246 738 A1**
(43) Date of publication of application: **03.11.2010**
(21) Application number: 10161473.3
(22) Date of filing: 29.04.2010
(51) Int. Cl.: G03F 1/14, G03F 1/00

(54) **Photomask and photomask/pellicle assembly**

(30) Priority: 30.04.2009 JP 2009110306
(71) Applicant: Shin-Etsu Chemical Co., Ltd., Chiyoda-ku, Tokyo (JP)
(72) Inventor: Shirasaki, Toru Shin-Etsu Chemical Co., Ltd., Gunma (JP)
(74) Representative: Vossius & Partner

(57) **Abstract**

A photomask is provided that includes a transparent substrate having a pattern region and a pellicle frame-mounting region formed thereon, wherein the pellicle frame-mounting region is formed outside the outer periphery of the pattern region, and at least the pellicle frame-mounting region is covered with a light shielding film. Specifically, there is provided a pellicle-equipped photomask comprising a photomask comprising a pellicle frame-mounting region covered with a light shielding film formed outside the outer periphery of the pattern region on a transparent substrate; and a pellicle comprising at least a pellicle film and a pellicle frame, the pellicle frame being mounted on the pellicle frame-mounting region.

## Description

The present invention relates to a photomask used in producing a semiconductor integrated circuit such as an LSI or a ULSI, a CCD (a charge coupled devices), and a LCD (a liquid crystal display).

As a method for producing a photomask, on a transparent substrate such as quartz glass, generally a chromium film for a light shielding film is deposited using a sputtering method, a vacuum deposition method or etc. After a resist film is coated on the deposition, the pattern of the resist film is formed by photolithography using electron beam (EB) exposure device, etc. Using the resist pattern as a mask, the intended parts of the chromium-based film are etched so as to expose the substrate. Then the photomask was obtained by peeling off the resist film. The types of resist can be classified into the positive and negative working resists. In the case of positive type, the light shielding film remains on the outer peripheral region. On the other hand, in the case of the negative type, the light shielding film on the outer peripheral region is removed and the substrate is exposed.

After the pattern formation, the photomask is completed with an examination or the like of the pattern for ensuring no defects or the like. After the completion of the photomask, a pellicle is mounted thereon to protect the pattern from foreign substances. The pellicle generally comprises a very thin organic film, an aluminium frame which supports the organic film, and an adhesive which affixes the frame to the photomask. In order to protect the pattern region, the pellicle has slightly larger dimensions than the pattern region, and is mounted on the substrate outside the outer periphery of the pattern.

Furthermore, for example, photomasks described in JP-A-5-107745 and JP-A-2008-175952 (JP-A denotes a Japanese unexamined patent application publication) are known.

JP-A-5-107745 discloses a photomask mounted with a pellicle, wherein the light shielding material at least at the part where a frame part of the pellicle and the photomask contact each other is removed.

JP-A-2008-175952 discloses a photomask mounted with a pellicle comprising a substrate made of a planar glass; and a light shielding film and an oxide film successively layered on one surface of the substrate, between a region that excludes a product pattern part and an adhesive part of the pellicle.

A photomask is used as a master plate for a pattern to be imaged on a silicon wafer in an exposure device for lithography. There is a case that a pellicle has to be replaced because foreign matter are generated, or the pellicle film becomes cloudy or tears due to the long-term use. In this case, first, the pellicle is removed from the photomask, the photomask is washed and mounted with another new pellicle. However, there is a problem that a long-term used pellicle is difficult to remove from the photomask. This problem is pronounced especially when the pellicle is mounted on quartz glass having no light shielding film.

The present invention has been accomplished in order to solve the above-mentioned problem. That is, it is an object of the present invention to provide a photomask, in which a pellicle can be easily removed from the photomask after use.

The above-mentioned object of the present invention has been attained by means (1) below, which is described together with preferred embodiments (2) to (4).
(1) A photomask comprising a transparent substrate having a pattern region and a pellicle frame-mounting region both defined thereon, wherein the pellicle frame-mounting region is defined outside the outer periphery of the pattern region, and at least the pellicle frame-mounting region is covered with a light shielding film,
(2) the photomask according to (1), wherein the photomask is intended for use with a negative-working resist,
(3) the photomask according to (1), wherein the transparent substrate and the light shielding film formed in the pellicle frame-mounting region are in direct contact with each other,
(4) the photomask according to (1), wherein the transparent substrate is a quartz glass substrate.

According to the present invention, there can be provided a photomask, in which a pellicle is easily removed from the photomask after use.

### BRIEF DESCRIPTION OF THE DRAWINGS

FIG. 1 A schematic plan view showing one example of the photomask of the present invention.
FIG. 2 A schematic plan view showing one example of the photomask mounted with pellicle (also called 'pellicle-equipped photomask') of the present invention.
FIG. 3 A schematic cross-sectional view taken along line a-a of FIG. 2 showing one example of the photomask mounted with a pellicle according to the present invention.
FIG. 4 A schematic plan view showing one example of a conventional photomask prior to being mounted with a pellicle.

### EXPLANATION OF REFERENCE NUMERALS AND SYMBOLS

- 10:: Photomask
- 12:: Transparent substrate
- 14:: Pattern region
- 16:: Light shielding film
- 18:: Pellicle frame-mounting region
- 20:: Photomask mounted with pellicle (Pellicle-equipped photomask)
- 22:: Pellicle film
- 24:: Pellicle frame
- 26:: Pressure-sensitive adhesive layer
- 28:: Adhesive layer

A photomask of the present invention comprises a light shielding film formed in a pellicle frame-mounting region outside the outer periphery of the pattern region on a transparent substrate.

Particularly, the photomask of the present invention is suitably used as a photomask with a negative-working resist.

Furthermore, a pellicle-equipped photomask (photomask-pellicle assembly) of the present invention comprises the above-described photomask; and a pellicle comprising a pellicle film and a pellicle frame, the pellicle frame being mounted on the pellicle frame-mounting region.

The present invention is explained in detail below by reference to the drawings.

As a result of an intensive investigation by the present inventors to attain the above-described object, it has been found that it is useful for removing the pellicle from the photomask after use to form a light shielding film in a pellicle frame-mounting region outside the outer peripheral region of the photomask.

When a photomask is used in an exposure machine for photography, a light shielding plate is generally mounted on the outer peripheral region outside the pattern region so that the outer peripheral region where the pellicle is affixed is not irradiated directly with exposure light. However, it has been found that exposure light which transmits through a pattern can be scattered by the pattern, and the scattered light, etc. can sometimes propagate in the transparent substrate such as a quartz glass substrate to reach the outer peripheral region of the photomask.

The present inventors have found that, in the case of a photomask without the light shielding film outside the outer peripheral region, the scattered light impinges on the adhesive layer of the pellicle and denatures the adhesive of the pellicle, and this is the reason why the pellicle is difficult to remove from the photomask after use.

The damage of the adhesive, for example, may cause the adhesive to become harder, and, in some cases, may cause hard sticking of the pellicle on the transparent substrate surface, making the removal of the used pellicle more difficult.

Particularly, in the case of a photomask using a negative working resist, a light shielding film formed outside the outer peripheral region prevents the scattered light which propagates through the transparent substrate from impinging on the adhesive layer of the pellicle.

Furthermore, even in the case of using a negative working resist, it is preferable to leave the light shielding film all around the outer periphery of the pattern region, but it is necessary to irradiate the region where the light shielding film is allowed to remain by EB exposure machine, etc. restulting in a problem that the throughput decreases with the increase of the remaining area of the shielding film. Therefore, if the light shielding film is subjected to be left only on the pellicle frame-mounting region, throughput degradation can be prevented because only a small region is required for irradiation.

Furthermore, when scattered light impinges on the adhesive layer, the adhesive may be decomposed by the scattered light and generate decomposition gas. In this case, the decomposition gas is released within the pellicle enclosing space, and may undergo a reaction upon exposure to light to cause a growing amount of foreign matter on the pattern. The prevention of the scattered light from impinging on the adhesive layer of the pellicle according to the present invention can restrain generating decomposition gas from the adhesive.

A transparent substrate is used in the photomask of the present invention.

The transparent substrate used in the present invention is not particularly limited, and any known substrate may be used. Among them, a glass substrate such as a quartz glass substrate or a soda glass substrate is preferable, and a quartz glass substrate is particularly preferable.

Furthermore, the pattern region on the transparent substrate of the photomask of the present invention is not particularly limited, and may be any region where the desired pattern is formed. Furthermore, the material for the pattern formed in the pattern region is not particularly limited, and any known method using any known material may be used for forming a pattern. It is preferable that the pattern region is covered with a light shielding material in a pattern-wise fashion, more preferable that the pattern in the pattern region is formed using a light shielding film, and particularly preferable that the pattern is formed together with the pellicle frame-mounting region of a light shielding film.

The photomask of the present invention is a photomask comprising a light shielding film formed in the pellicle frame mounting region outside the outer periphery of the pattern region on the transparent substrate.

Examples of the light shielding film include chromium, a metal silicide such as molybdenum silicide, zirconium silicide, or tungsten silicide, and a nitrogen atom- or an oxygen atom-containing film thereof.

The method for forming the light shielding film is not particularly limited, and any known method, for example, such as a sputtering method, a vacuum deposition method, or CVD method may be used.

It is preferable to use a chromium-based film as the light shielding film when a quartz glass substrate is used as a transparent substrate because good etching selectivity between the quarts glass and the light shielding film can be obtained.

In the case of exposure wavelength being 200 nm or less (e.g. 193 nm), the use of a metal silicide-based film (an oxygen atom or a nitrogen atom can be included therein) has advantages, that is, for example, reflectivity can be decreased to the prescribed level, the thickness of the light shielding film can be reduced, and fluorine etching which is favorable for fine patterning can be employed.

The thickness of the light shielding film is appropriately selected as needed, preferably 5 to 500 nm, more preferably 10 to 200 nm, and yet more preferably 15 to 150 nm.

Furthermore, the light shielding film may be a laminate constituted of a plurality of metal films.

A "pellicle frame-mounting region" on the transparent substrate refers to the setting position of the pellicle frame on the transparent substrate, or the setting position and its proximity of the pellicle frame when the pellicle is mounted, and the region needs only to be large enough to prevent direct impingement of scattered light when exposed. It should be understood that the proximity of the setting position includes both inside and outside of the space enclosed by pellicle frame.

The width of the light shielding film (the width of the light shielding film in the direction of the thickness of the pellicle frame) in the pellicle frame-mounting region needs to be at least equal to the thickness of the frame, and, if possible, in addition to the thickness of the frame, preferably at least 1 mem wide from each side of the frame, more preferably at least 2 mm wide, and yet more preferably at least 5 mm wide. The width of the light shielding film is preferably not more than 10 mm wide from each side of the frame.

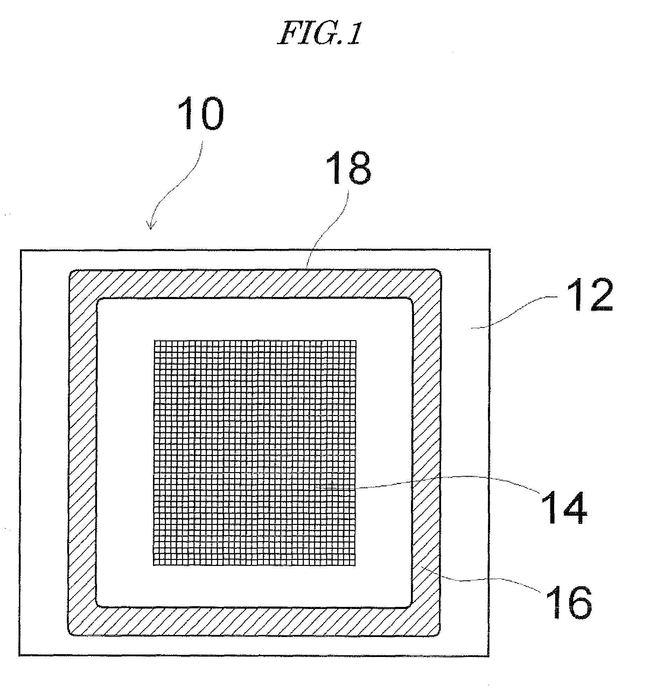

Furthermore, the pellicle frame-mounting region needs to conform to the shape of the pellicle frame used. The shape of the pellicle frame-mounting region may be, for example, a rectangular frame shape with rounded corners as shown in FIG. 1 below, a square frame shape, or a round doughnut shape.

Preferably, the photomask of the present invention comprises the pellicle frame-mounting region covered with a light shielding film and the pattern region formed of the light shielding film.

It is preferably that there is a space between the pattern region and the pellicle frame-mounting region. The space may be, or may not be, covered with a light shielding film. It is more preferable that the space is transparent and is not covered with a light shielding film.

FIG. 1 is a schematic plan view showing one example of the photomask of the present invention.

Photomask 10 shown in FIG. 1 comprises a light shielding film 16 formed in pellicle frame-mounting region 18 outside the outer periphery of the pattern region 14 on a transparent substrate 12, and a pattern formed in the central part of pattern region 14 on the transparent substrate 12.

The pattern shape of the pattern region 14 in the photomask 10 is not particularly limited, but may be any desired shape for a photomask.

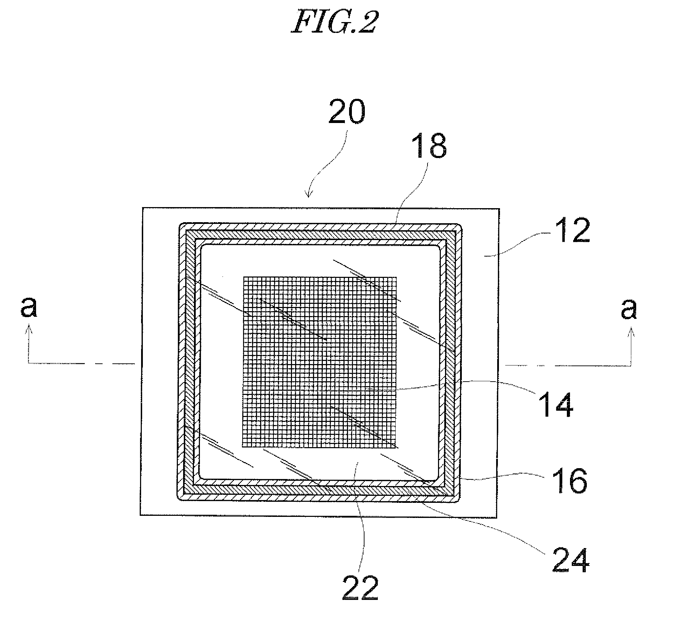

FIG. 2 is a schematic plan view showing one example of the photomask mounted with a pellicle according to the present invention (the pellicle-equipped photomask of the present invention).

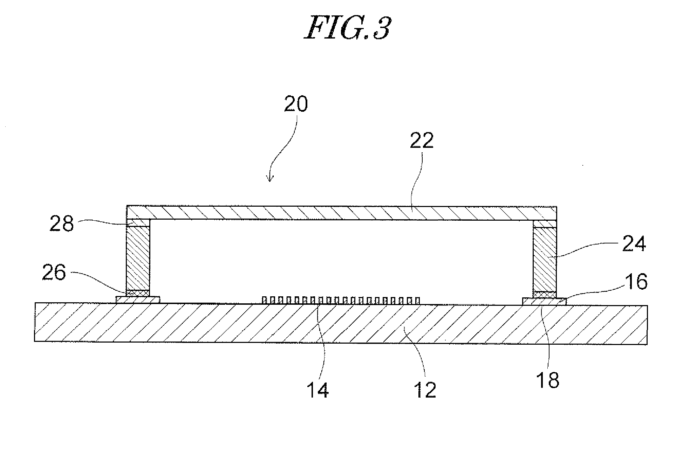

Furthermore, FIG. 3 is a schematic cross-sectional view taken along line a-a of FIG. 2 showing one example of the photomask mounted with a pellicle according to the present invention.

Furthermore, the example of the photomask mounted with a pellicle according to the present invention shown in FIG. 2 uses the photomask of FIG. 1.

Photomask mounted with a pellicle (pellicle-equipped photomask) 20 comprises the light shielding film 16 formed in the pellicle frame-mounting region 18 outside the outer periphery of the pattern region 14 on the transparent substrate 12, and a pellicle composed of a pellicle film 22, a pellicle frame 24, a pressure-sensitive adhesive layer 26, and an adhesive layer 28 on the light shielding film 16 in the pellicle frame-mounting region 18. Description of pressure-sensitive adhesive layer 26 and adhesive layer 28 are omitted in FIG. 2.

For more detail, as shown in FIG. 3, in pellicle frame-mounting region 18 on a transparent substrate 12, the light shielding film 16 is formed in contact with the transparent substrate 12, in the central part of the light shielding film 16, the pellicle frame 24 is fixed with a lower end face thereof via a pressure-adhesive layer, and furthermore on the upper end face of the pellicle frame 24, the pellicle film 22 is stretched via adhesive layer 28.

The pellicle which can be mounted to the photomask of the present invention is not particularly limited and any known pellicle may be used, and, for example, is similar to that used for semiconductor lithography, or for a lithographic step of large liquid crystal display panel production, etc. The material of the pellicle may be also any of known materials, as described above.

The pellicle preferably comprises a pellicle film, a pellicle frame, and a pressure-sensitive adhesive layer via which the light shielding film and the pellicle frame are affixed to each other.

The material of the pellicle film is not particularly limited and, for example, an amorphous fluorine polymer, etc. that has been conventionally used for an excimer laser is used. Examples of the amorphous fluorine polymer include Cytop (product name, manufactured by Asahi Glass Co. Ltd.) and Teflon (Registered Trademark) AF (product name, manufactured by DuPont). These polymers may be used by dissolving them in a solvent as necessary when preparing the pellicle film, and may be dissolved as appropriate in, for example, a fluorine-based solvent.

With regard to the base material of the pellicle frame, a conventionally aluminum alloy material, and preferably a JIS A7075, JIS A6061, JIS A5052 material, etc., is used, but when an aluminum alloy is used it is not particularly limited as long as the strength as a pellicle frame is guaranteed. The surface of the pellicle frame is preferably roughened by sandblasting or chemical abrasion prior to providing a polymer coating. In the present invention, a method for roughening the surface of the frame may employ any of conventionally known methods. It is preferable to employ a method for roughening the surface involving blasting the aluminum alloy material surface with stainless steel, carborundum, glass beads, etc., followed by further chemical abrading with NaOH, etc.

The adhesion between the pellicle film and the pellicle frame may be carried out by any known method, and, an adhesive, for example, can be suitably used for the adhesion. An adhesive is not particularly limited, and any known adhesive may be used.

Furthermore the pellicle frame may be provided with an atmospheric pressure adjustment hole (vent), and further with a dust filter for the purpose of removing particles.

The adhesive used in the pressure-sensitive adhesive layer, via which the light shielding film and the pellicle frame are affixed to each other, may be appropriately selected from various types of adhesives, among which an acrylic adhesive, a styrene-ethylene/butylene-styrene (SEBS) based adhesive, and a silicone-based adhesive may preferably be used, and a silicone-based adhesive may more preferably be used.

The method for forming a pattern of the present invention can be carried out utilizing a well-known lithography technology, for example, involving each process of coating a resist film on a substrate for producing a integrated circuit, heat treatment (prebaking), exposure, heat treatment (post-exposure baking, PEB), and development.

The method for forming a pattern of the present invention preferably includes the exposure process of exposing a substrate having a resist film to a high energy radiation through a photomask of the present invention and the development process of developing the exposed substrate with a developer. Furthermore, if necessary, any other step may be added.

Examples of the materials of a substrate for producing an integrated circuit include Si, SiO₂, SiN, SiON, TiN, WSi, BPSG, SOG, organic anti-reflecting film, Cr, CrO, CrON, and MoSi.

The resist composition is coated on the substrate for producing an integrated circuit by a suitable coating technique such as spin coating, roll coating, flow coating, dip coating, spray coating, or doctor coating so that the coating thickness is 0.01 to 2.0 µm. The coating is baked on a hot plate preferably at a temperature of 60°C to 150°C for 1 to 10 minutes, and more preferably 80°C to 140°C for 1 to 5 minutes.

A relationship of a reduced thickness of resist film to an etch selectivity ratio between resist film and processable substrate imposes severer limits on the process. Under consideration is the tri-layer process in which a silicon-containing intermediate layer, an undercoat layer having a high carbon density and high etch resistance, and a processable substrate are laminated in sequence from top to bottom beneath a resist layer. The etch selectivity ratio between the silicon-containing intermediate layer and the undercoat layer is high on etching with oxygen gas, hydrogen gas, etc., which allows for thickness reduction of the silicon-containing intermediate layer. A relatively high etch selectivity ratio is also obtained between the monolayer resist and the silicon-containing intermediate layer, which allows for thickness reduction of the monolayer resist. In this case, the method for forming the undercoat layer includes a coating and baking method and a Chemical Vapor Deposition (CVD) method. In the case of coating method, novolac resins and resins obtained by polymerization of fused ring-containing olefins are used, and in the CVD film formation, gases such as butane, ethane, propane, ethylene and acetylene are used. For the silicon-containing intermediate layer, either a coating method or a CVD method may be employed. The coating method uses silsesquioxane, cage oligomeric silsesquioxane (POSS), etc., while the CVD method uses silane gases as the reactant. The silicon-containing intermediate layer may have an antireflection function with a light absorbing ability and have photo-absorptive groups like phenyl groups, or it may be a SiON film. An organic film may be formed between the silicon-containing intermediate layer and the photoresist, and the organic film in this case may be an organic antireflective coating. After the photoresist film is formed, deionized water rinsing (or post-soaking) may be carried out for extracting the acid generator, etc. from the film surface or washing away particles, or a protective film may be coated.

Examples of the light source for the exposure process include UV rays, deep UV rays (near UV rays), electron beams, X-rays, excimer laser light, y rays, and synchrotron radiation.

Particularly among high energy radiations, deep UV with a wavelength of 254 to 193 nm, vacuum UV with a wavelength of 157 nm, electron beams, soft X-rays, X-rays, excimer laser light, y rays and synchrotron radiation are best suited for micro-patterning. Specifically, KrF excimer laser (248 nm), ArF excimer (193 nm), F₂ laser (157 nm) may be exemplified.

Exposure dose is preferably about 1 to 200 mJ/cm², and more preferably about 10 to 100 mJ/cm².

The film is preferably baked on a hot plate (post-exposure baking, PEB) after the exposure process and before the developing process. The post-exposure bake condition is preferably at a temperature of 60°C to 150°C for 1 to 5 minutes, and more preferably 80°C to 120°C for 1 to 3 minutes.

As a developer used in the developing process, being not particularly limited, any known developer may be used in accordance with the resist films used.

Furthermore, in the development process, conventional techniques such as a dip technique, a puddle technique, and a spray technique may be used for development.

Furthermore, the method for peeling the pellicle from the photomask of the present invention is not particularly limited, and any known method may be used.

Above all, it is preferable to heat the pressure-sensitive adhesive layer when peeling the pellicle.

It is preferable to heat the photomask of the present invention and/or the pellicle frame which are in contact with the adhesive layer, and more preferable to heat the photomask of the present invention.

As a specific method, any method involving radiant heat of a high temperature body such as a hot air dryer, an IR lamp, or a hot plate, a method involving heat conduction by contact with a high temperature body such as a hot plate, a method in which an induction current is passed through the frame by utilizing high-frequency induction heating without making contact with the adhesive layer so as to heat only the frame efficiently and indirectly heat the adhesive layer, etc. are possible.

In a preferred stripping method, when the pellicle is stripped from the photomask of the present invention, stripping is carried out in a state in which a pressure-sensitive adhesive layer between the pellicle and the photomask of the present invention is heated. The heating temperature for the pressure-sensitive adhesive layer is preferably 40°C to 150°C, more preferably 50°C to 120°C, and particularly preferably 60°C to 120°C. In the above-mentioned heating temperature range, the pressure-sensitive adhesive is sufficiently softened, and it is possible to carry out stripping smoothly; it is also possible to prevent the adhesive from being left as an adhesive residue on the photomask surface.

The heating temperature can be controlled, for example, by detecting the temperature with a thermistor thermometer.

In a method for stripping the pellicle from the photomask, the pellicle can be stripped as necessary by slowly pulling up from a long or short side of the frame.

Furthermore, in stripping the pellicle, it is prefered to apply a load in a direction in which the photomask and the pellicle frame are stripped apart. In the photomask mounted with a pellicle of the present invention, a force that pulls up the pellicle frame with the pellicle-mounted face upward may be applied, or a force that pulls down in the vertical direction with the pellicle-mounted face downward may be applied.

The magnitude of the applied load may be appropriately selected, but is preferably 0.1 to 2 kgf, and more preferably 0.2 to 1.5 kgf.

Application of a load may be carried out by means of weights using, for example, four jig holes placed in the pellicle longer sides in a direction in which the pellicle and the photomask are stripped apart. A load in the above-mentioned range is preferably applied while heating at a temperature in the above-mentioned heating range.

When it is necessary to apply a force to pull upward or a force to strip laterally, the direction of the force of a weight may be changed using a pulley as appropriate.

Furthermore, after the pellicle is stripped, the photomask of the present invention is washed according to the known method, and after passing inspection, a new pellicle is affixed to the photomask for use.

Preferred examples of the washing method include a washing method using ozone (O₃)-containing water (ozone water).

### EXAMPLES

The present invention is explained below more specifically by reference to Examples.

### (Example 1)

A chromium (Cr) film was formed at a film thickness of 100 nm by a sputtering method on a 6 inch square-shaped synthetic quartz glass substrate. A negative-working EB resist liquid was applied thereon, thus giving a 500 nm resist film. Subsequently, exposure and development were carried out using an EB exposure system. A pellicle-mounting section was also exposed in this stage.

Subsequently, a resist pattern thus obtained was used as a mask, and the chromium film was subjected to patterning by dry etching. Subsequently, the resist layer was removed, thus completing a photomask. In this photomask, the Cr film was formed in the pellicle-mounting region (FIG. 1).

The Cr film in the pellicle-mounting region was formed, as shown in FIG. 1, in a square shape having four rounded corners so that the film thickness was 100 nm, the width was 4 mm, the upper and lower lengths from the edges in the vertical direction of FIG. 1 of the transparent substrate to the edges of the Cr film in the pellicle-mounting region were both 0.5 mm, and the left and right lengths from the edges in the left-and-right direction in FIG. 1 of the transparent substrate to the edges of the Cr film in the pellicle-mounting region were both 14 mm.

A pellicle employing a transparent fluorine resin as a pellicle film, aluminum as a pellicle, frame, and a silicone pressure-sensitive adhesive as a pellicle pressure-sensitive adhesive was mounted on the photomask completed above. Here, the pellicle was mounted on the Cr film in a pellicle-affixing section.

The pellicle frame used had frame outer dimensions of 149 mm × 122 mm and a frame thickness of 2 mm.

A pattern region near the center of the photomask was irradiated with an ArF laser from the quartz glass side of the photomask. The laser intensity per pulse was 0.1 mJ/cm², and the pulse repetition frequency was 1,000 Hz. Furthermore, the irradiation energy level was 10,000 J/cm². A light shielding plate was placed on an outer peripheral region other than the pattern region of the photomask.

The pellicle was removed from the photomask after irradiation. The removal was carried out in a state in which the photomask was heated at 60°C. Peeling was carried out easily. Furthermore, when the area of the photomask where the pellicle had been affixed was examined after the pellicle was removed, a pressure-sensitive adhesive residue of about 10 µm thickness was observed, but this pressure-sensitive adhesive residue could be washed off by washing with ozone water for 10 minutes.

### (Comparative Example 1)

A chromium film was formed at a film thickness of 100 nm by a sputtering method on a 6 inch square-shaped synthetic quartz glass substrate. A negative-working EB resist liquid was applied thereon, thus giving a 500 nm resist film. Subsequently, exposure and development were carried out using an EB exposure system. A pellicle-mounting section was also exposed in this stage.

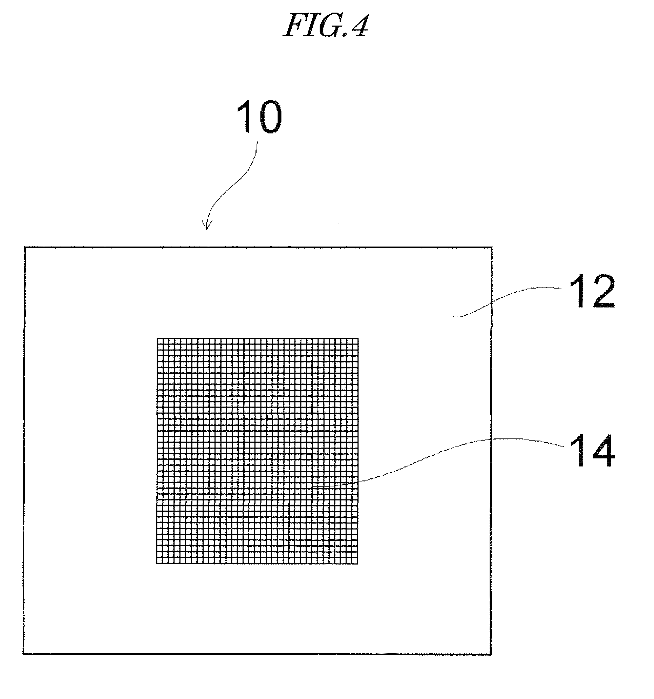

Subsequently, a resist pattern thus obtained was used as a mask, and the chromium film was subjected to patterning by dry etching. Subsequently, the resist layer was removed, thus completing a photomask. In this photomask, the light shielding film on the outer peripheral region was removed (FIG. 4).

A pellicle, as was used in Example 1, employing a transparent fluorine resin as a pellicle film, aluminum as a pellicle frame, and a silicone pressure-sensitive adhesive as a pellicle pressure-sensitive adhesive was mounted on the photomask completed above. Here, the pellicle was mounted on the peripheral region of the quartz glass.

A pattern region near the center of the photomask was irradiated with an ArF laser from the quartz glass side of the photomask. The laser intensity per pulse was 0.1 mJ/cm², and the pulse repetition frequency was 1,000 Hz. Furthermore, the irradiation energy level was 10,000 J/cm². A light shielding plate was placed on an outer peripheral region other than the pattern region of the photomask.

The pellicle was removed from the photomask after irradiation. The removal was carried out in a state in which the photomask was heated at 60°C. Peeling was more difficult to carry out than in Example 1. Furthermore, when the area of the photomask where the pellicle had been affixed was examined after the pellicle was removed, a pressure-sensitive adhesive residue of about 100 µm thickness was observed, and this pressure-sensitive adhesive residue could not be washed off by washing with ozone water for 10 minutes.

## Claims

1. A photomask comprising a transparent substrate having a pattern region and a pellicle frame-mounting region both defined thereon, wherein the pellicle frame-mounting region is defined outside the outer periphery of the pattern region, and at least the pellicle frame-mounting region is covered with a light shielding film.

2. The photomask according to Claim 1, wherein the transparent substrate and the light shielding film formed on the pellicle frame-mounting region are in direct contact with each other.

3. The photomask according to Claim 1, wherein the transparent substrate is a quartz glass substrate.

4. The photomask according to any one of Claims 1 to 3, wherein the light shielding film is a film comprising as a main component chromium, a metal silicide, or a metal silicide comprising a nitrogen atom or an oxygen atom.

5. The photomask according to any one of Claims 1 to 4, wherein the light shielding film has a thickness of 5 to 500 nm.

6. The photomask according to any one of Claims 1 to 5, wherein a space between the pellicle frame-mounting region and the pattern region is not covered with the light shielding film.

7. Use of the photomask according to any one of Claims 1 to 6 with a negative-working resist.

8. A pattern formation method, the method comprising:
a mounting step of mounting via a pressure-sensitive adhesive layer a pellicle comprising a pellicle film and a pellicle frame on the pellicle frame-mounting region of the photomask according to any one of Claims 1 to 7;
an exposure step of exposing a substrate comprising a resist film with high energy radiation via the photomask;
a development step of developing the exposed substrate using a developer;
and
a stripping step of stripping the pellicle from the photomask.

9. The pattern formation method according to Claim 8, wherein the pressure-sensitive adhesive layer is a layer comprising a silicone-based adhesive.

10. The pattern formation method according to Claim 8 or 9, comprising, subsequent to the stripping step, a washing step of washing the photomask with an ozone-containing water.

11. A pellicle-equipped photomask comprising:
the photomask according to any one of Claims 1 to 6; and
a pellicle comprising at least a pellicle film and a pellicle frame,
the pellicle frame being mounted on the pellicle frame-mounting region.

12. The pellicle-equipped photomask according to Claim 11, wherein the light shielding film in the thickness direction of the pellicle frame is formed so as to have the width of the width of the pellicle frame plus at least 1 mm but not more than 10 mm from each side of the pellicle frame.

13. Use of the pellicle-equipped photomask according to Claim 11 or 12 with a negative-working resist.
